# EUROPEAN PATENT APPLICATION

(11) **EP 4 258 443 A1**
(43) Date of publication of application: **11.10.2023**
(21) Application number: 21960828.8
(22) Date of filing: 18.10.2021
(51) Int. Cl.: H01M 50/258, H01M 50/213, G01R 1/06

(54) **SAMPLING ASSEMBLY, MANUFACTURING METHOD THEREFOR, BATTERY, AND ELECTRICAL DEVICE**

(71) Applicant: Contemporary Amperex Technology Co., Limited, Ningde City, Fujian 352100 (CN)
(72) Inventor: QIN, Feng, Ningde City, Fujian 352100 (CN); JI, Hongye, Ningde City, Fujian 352100 (CN); WANG, Zhi, Ningde City, Fujian 352100 (CN)
(74) Representative: Gong, Jinping
(86) International application number: PCT/CN2021/124390
(87) International publication number: WO 2023/065067

(57) **Abstract**

This disclosure provides a sampling assembly and a manufacturing method thereof, a battery, and an electric device. The sampling assembly is used in a battery, where the battery includes at least two battery cells arranged along a first direction. The sampling assembly includes: a sampling member configured to transmit sample signals, the sampling member having a lead; a support base configured to provide support between two of the battery cells adjacent along the first direction; a conductive connecting piece, the conductive connecting piece being provided on the support base, and the lead being connected to the conductive connecting piece; and a bonding member, one end of the bonding member being for connecting to the conductive connecting piece, and the other end of the bonding member being for connecting to the battery cell to collect sample signals of the battery cell. In embodiments of this disclosure, the assembly of the sampling assembly to the battery requires no downward pressure, and only a laser welding device is needed to connect the bonding member to the conductive connecting piece and to connect the bonding member to the battery cell. This makes the assembly more efficient and also avoids deformation or damage.

## Description

### TECHNICAL FIELD

This disclosure relates to the field of electrochemical technologies and, in particular, to a sampling assembly and a manufacturing method thereof, a battery, and an electric device.

### BACKGROUND

This section provides only background information related to this disclosure, which is not necessarily the prior art.

To monitor the operating status of a battery cell in a battery, a sampling assembly is commonly provided in the battery to facilitate real-time measurement of operating parameters of the battery cell, such as voltage, current, and temperature. In the related art, the sampling assembly is assembled through an arduous process, resulting in low assembly efficiency. Moreover, the sampling assembly is susceptible to deformation or damage during assembly, which ultimately affects the yield of final products.

### SUMMARY

An objective of embodiments of this disclosure is to provide a sampling assembly and a manufacturing method thereof, a battery, and an electronic device to improve the assembly efficiency of the sampling assembly and the yield of assembled products.

Embodiments of a first aspect of this disclosure provide a sampling assembly for a battery, the battery including at least two battery cells arranged along a first direction, characterized in that the sampling assembly includes: a sampling member configured to transmit sample signals, the sampling member having a lead; a support base configured to provide support between two of the battery cells adjacent along the first direction; a conductive connecting piece, the conductive connecting piece being provided on the support base, and the lead being connected to the conductive connecting piece; and a bonding member, one end of the bonding member being for connecting to the conductive connecting piece and the other end of the bonding member being for connecting to the battery cell to collect sample signals of the battery cell.

According to the sampling assembly in the embodiments of this disclosure, the sampling member of the sampling assembly is connected to the conductive connecting piece via the lead, and the conductive connecting piece is connected to the battery cell in the battery via the bonding member, thereby achieving an electrical connection between the sampling member and the battery cell. In this way, operating parameters of the battery cell are collected by the sampling member, and the sampling member further transmits the sample signals characterizing the operating parameters of the battery cell to an external monitoring device. In addition, in the embodiments of this disclosure, the bonding member is configured to connect the conductive connecting piece to the battery cell. As compared with a way of sleeving the battery cell with a sampling ring in the related art, the sampling assembly in the embodiments of this disclosure requires no downward pressure during assembly onto the battery, and only a laser welding device is used to connect the bonding member to the conductive connecting piece and to connect the bonding member to the battery cell. This makes the assembly more efficient and also avoids deformation or damage, that is, the assembly yield is higher. In summary, the sampling assembly in the embodiments of this disclosure is conducive to improving the assembly efficiency and the yield of the products.

In some embodiments of this disclosure, the support base includes a positioning portion and a support portion, the positioning portion being configured to fit the profile of the battery cell, and the support portion being located between two positioning portions adjacent along the first direction. This allows the support base to be positioned stably between the two battery cells adjacent along the first direction.

In some embodiments of this disclosure, the profile of the battery cell includes a side face of the battery cell and an end face of the battery cell. In this way, the support base provides stable support between two of the battery cells adjacent along the first direction and is at an end of the battery cell. This helps reduce the length of the bonding member and thus shorten the working stroke of the laser welding device during laser welding, thereby improving the efficiency of assembling the sampling assembly to the battery.

In some embodiments of this disclosure, the conductive connecting piece is a sheet structure with all parts provided on the support portion. By programming the laser welding device, it is possible to use the laser welding device to weld the bonding member to the conductive connecting piece, as well as to weld the bonding member to a pole of the battery cell.

In some embodiments of this disclosure, the conductive connecting piece includes a first section, a second section, and a third section connected in sequence, the first section and the third section not being coplanar so that the conductive connecting piece forms a stepped structure, the lead being connected to the first section, and one end of the bonding member being connected to the third section. As a result, the length of the bonding member can be further reduced, and therefore the working stroke of the laser welding device during laser welding can be further reduced, thereby further improving the efficiency of assembling the sampling assembly to the battery.

In some embodiments of this disclosure, the support base further includes a spacer, the spacer being provided on a side of the support portion back from the battery cell, and the spacer being configured to space apart adjacent sampling assemblies arranged along a second direction. When the sampling assembly is assembled on the battery, the spacer can abut against a support base of an adjacent sampling assembly, thereby enhancing positioning stability of the support base and avoiding tampering of the support base in the second direction.

In some embodiments of this disclosure, the third section is fixed to the spacer. As the spacer is disposed on the side of the support portion back from the battery cell, the spacer is in a position roughly side by side with the pole of the battery cell. The third section of the conductive connecting piece being fixed to the spacer can meet the position requirements of the third section, and also helps improve the structural strength and structural rigidity of the conductive connecting piece, so as to prevent the conductive connecting piece from deforming when subjected to external forces.

In some embodiments of this disclosure, the battery cell is provided with a pole protruding from the end face of the battery cell; and in a case that the support base provides support between the two battery cells adjacent along the first direction, the bonding member has substantially same heights at two ends. In this way, the laser welding device can sequentially perform the operations of welding the bonding member to the third section and welding the bonding member to the pole without adjusting the downward pressure to further improve the assembly efficiency.

In some embodiments of this disclosure, the conductive connecting piece is provided with a wrapping portion for wrapping at least part of the lead. This creates a more secure connection between the lead and the conductive connecting piece, thereby preventing accidental separation thereof.

In some embodiments of this disclosure, the sampling assembly further includes a metal gasket, the metal gasket being provided between the conductive connecting piece and the support base. Even if the conductive connecting piece is welded through, the bonding member can still be electrically connected to the conductive connecting piece through the metal gasket, thereby preventing poor welding.

In some embodiments of this disclosure, the support base is made of an insulating material. Thus, the support base can separate the bonding member, the conductive connecting piece, and the battery cell, ensuring insulation performance.

In some embodiments of this disclosure, the support portion is an internally hollow trapezoidal block, stiffeners being provided in a cavity of the trapezoidal block. The support portion of the support base is an internally hollow trapezoidal block, and a top face of the trapezoidal block is a flat plane that can withstand the welding pressure during laser welding. In addition, the support base has a hollow interior, so that the overall support base is an evenly thick structure, facilitating implementation of the injection molding process.

Embodiments of a second aspect of this disclosure provide a battery including the sampling assembly in any one of the embodiments of the first aspect. The battery further includes at least two battery cells arranged along a first direction, the support base provides support between two of the battery cells adjacent along the first direction, and the other end of the bonding member is for connecting to the battery cell.

Embodiments of a third aspect of this disclosure provide an electric device, characterized by including the battery in any one of the embodiments of the second aspect.

Embodiments of a fourth aspect of this disclosure provide a sampling assembly manufacturing method, a battery including at least two battery cells arranged along a first direction. The method includes: providing a sampling member configured to transmit sample signals, the sampling member having a lead; providing a support base configured to provide support between two of the battery cells adjacent along the first direction; providing a conductive connecting piece, the conductive connecting piece being provided on the support base, and the lead being connected to the conductive connecting piece; and providing a bonding member, one end of the bonding member being for connecting to the conductive connecting piece, and the other end of the bonding member being for connecting to the battery cell to collect sample signals of the battery cell.

### BRIEF DESCRIPTION OF DRAWINGS

To describe technical solutions in some embodiments of this disclosure or in the prior art more clearly, the following briefly describes the accompanying drawings required for describing some embodiments or the prior art. Apparently, the accompanying drawings in the following descriptions show some embodiments of this disclosure, and persons of ordinary skill in the art may still derive others drawings from these accompanying drawings.
FIG. 1 is a schematic structural diagram of a vehicle employing a battery according to an embodiment of this application;
FIG. 2 is a schematic diagram of a battery according to an embodiment;
FIG. 3 is a schematic structural diagram of a battery according to an embodiment of this application;
FIG. 4 is a schematic structural diagram of a sampling assembly according to an embodiment of this application;
FIG. 5 is a schematic exploded view of a sampling assembly according to an embodiment of this application;
FIG. 6 is a schematic structural diagram of a battery from another perspective according to an embodiment of this application;
FIG. 7 is a schematic diagram of an enlarged structure of part A in FIG. 4;
FIG. 8 is a schematic structural diagram of a battery according to another embodiment of this application;
FIG. 9 is a schematic diagram of an enlarged structure of part B in FIG. 6;
FIG. 10 is a schematic structural diagram of a battery from another perspective according to another embodiment of this application;
FIG. 11 is a schematic structural diagram of a sampling assembly according to another embodiment of this application;
FIG. 12 a schematic exploded view of a sampling assembly according to another embodiment of this application; and
FIG. 13 is a schematic structural diagram of a conductive connecting piece of a sampling assembly according to another embodiment of this application.

### DESCRIPTION OF EMBODIMENTS

Example embodiments of this disclosure are described in more detail below with reference to the accompanying drawings. Although the example embodiments of this disclosure are shown in the accompanying drawings, it should be understood that this disclosure may be implemented in various forms and should not be limited by the embodiments set forth herein. On the contrary, the embodiments are provided to enable a more thorough understanding of this disclosure and completely convey the scope of this disclosure to persons skilled in the art.

It should be understood that the terms used herein are merely intended to describe specific embodiments rather than to limit this application. Unless otherwise clearly stated in the context, singular forms "a", "an", and "the" as used in this specification are intended to also include plural forms. The term "include", "comprise", "contain", and "have" are inclusive and thus indicate the presence of stated features, steps, operations, elements and/or parts but do not exclude the presence or addition of one or multiple other features, steps, operations, elements, components, and/or combinations thereof. The method steps, processes, and operations described in the specification are not to be construed as necessarily requiring that they be performed in the particular order in which they are described or illustrated, unless the order of performance is clearly stated. It should also be understood that additional or alternative steps may be used.

Although the terms first, second, third, and the like may be used in the specification to describe multiple elements, parts, regions, layers, and/or sections, such elements, parts, regions, layers, and/or sections should not be limited by such terms. These terms may be used only to distinguish one element, component, region, layer, or section from another region, layer, or section. Unless otherwise clearly stated the context, terms such as "first", "second", and other numerical terms used in the specification do not imply an order or sequence. Accordingly, the first element, part, region, layer, or section discussed below may be referred to as a second element, part, region, layer, or section without departing from the teachings of the example embodiments.

For ease of description, spatial relativity terms may be used in the specification to describe the relationship of an element or feature to another element or feature as illustrated in the figures, such as "inside", "outside", "inward", "outward", "below", "under", "above", and "over". These spatial relativity terms are intended to include different orientations of the apparatus in use or operation other than the orientation depicted in the figure. For example, if the apparatus in the figure is inverted, the element described as "below the other element or feature" or "under the other element or feature" will then be positioned as "above the other element or feature" or "over the other element or feature". Thus, the example term "under..." may include both upward and downward orientations. The apparatuses can be oriented in other ways, such as rotated by 90 degrees or placed in other orientations, and spatial relation descriptors used in this application are explained accordingly.

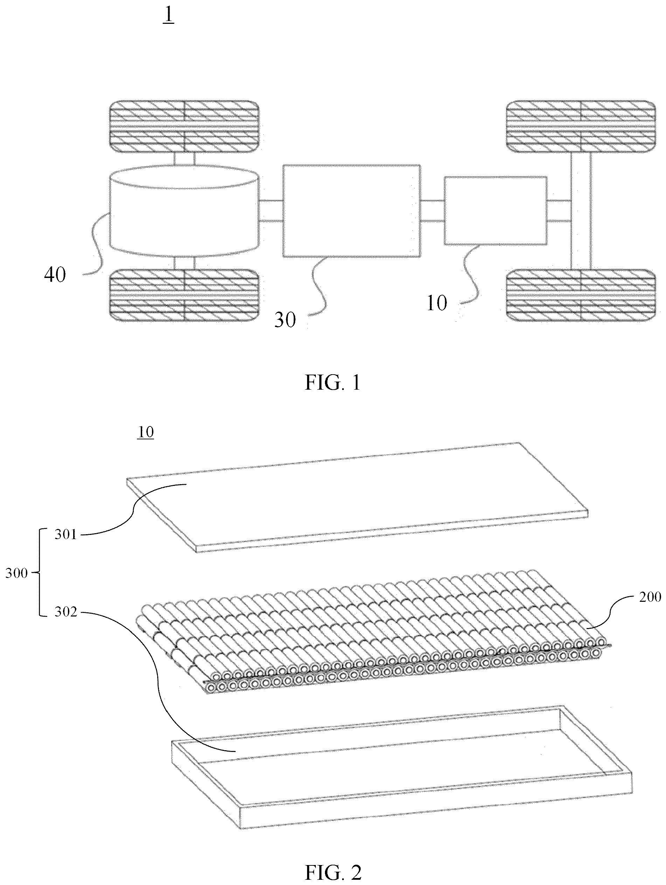

FIG. 1 is a schematic structural diagram of a vehicle 1 according to an embodiment of this application. The vehicle 1 may be a fossil fuel vehicle, a natural-gas vehicle, or a new energy vehicle, where the new energy vehicle may be a battery electric vehicle, a hybrid electric vehicle, a range-extended vehicle, or the like. A motor 40, a controller 30, and a battery 10 may be provided inside the vehicle 1, where the controller 30 is configured to control the battery 10 to supply power to the motor 40. For example, the battery 10 may be disposed at the bottom, front, or rear of the vehicle 1. The battery 10 may be configured to supply power to the vehicle 1. For example, the battery 10 may be used as an operational power source for the vehicle 1 which is configured for a circuit system of the vehicle 1, for example, to satisfy power needs of start, navigation, and running of the vehicle 1. In another embodiment of this application, the battery 10 can be used not only as the operational power source for the vehicle 1 but also as a driving power source for the vehicle 1, replacing or partially replacing fossil fuel or natural gas to provide driving traction for the vehicle 1.

As shown in FIG. 2, the battery 10 mentioned in the embodiments of this application is a single physical module that includes one or more battery cells 200 for providing a higher voltage and capacity. For example, the battery 10 mentioned in this application may include a battery module, a battery pack, or the like. A battery 10 typically includes a box 300 configured to enclose one or more battery cells 200. The box 300 can prevent liquids or other foreign matters from affecting charging or discharging of the battery cell. Specifically, the box 300 may include a top cover 301 and a box housing 302, with the top cover 301 and the box housing 302 snap-fitted together. The shape of the top cover 301 and the box housing 302 may be based on the combined shape of a plurality of battery cells 200.

A plurality of battery cells 200 may be connected in series and/or in parallel through a pole for various application scenarios. In some high-power application scenarios such as an electric vehicle, the application of the battery includes three levels: a battery cell, a battery module, and a battery pack. The battery module is formed by electrically connecting a specific quantity of battery cells and putting the battery cells into a frame to protect the battery cells from external impact, heat, vibration, and the like. The battery pack is a final state of a battery system assembled in an electric vehicle. A battery pack typically includes a box configured to enclose one or more battery cells. The box can prevent liquids or other foreign matters from affecting charging or discharging of the battery cell. A box typically includes a cover and a box housing. Most existing battery packs are formed by assembling various control and protection systems such as a battery management system (BMS) and a thermal management component on one or more battery modules. With the development of technologies, the battery module may be omitted, that is, the battery pack is directly formed by battery cells. With this improvement, weight energy density and volumetric energy density of the battery system are improved, and a quantity of components is remarkably reduced. The battery mentioned in this application includes a battery module or a battery pack.

In this application, the battery cell 300 may include a lithium-ion secondary battery, a lithium-ion primary battery, a lithium-sulfur battery, a sodium-lithium-ion battery, a sodium-ion battery, a magnesium-ion battery, or the like. This is not limited in the embodiments of this application. The battery cell may be cylindrical, flat, cuboid, or of other shapes, which is not limited in the embodiments of this application either. Battery cells are typically divided into three types by packaging method: cylindrical cell, prismatic cell, and pouch cell. The type of battery cell is not limited in the embodiments of this application either.

The technical solutions described in the embodiments of this application are applicable to various apparatuses that use batteries, for example, mobile phones, portable devices, notebook computers, electric bicycles, electric toys, electric tools, electric vehicles, ships, and spacecrafts. For example, spacecrafts include airplanes, rockets, space shuttles, and spaceships.

In practical applications, each battery cell cannot be exactly identical. Minor differences in some parameters (such as voltage, internal resistance, SOC (state of charge)) of the battery cells can cause the differences between the battery cells to amplify over usage time. These differences can compromise the consistency among the battery cells, impacting the overall performance of the battery, such as charge-discharge control and power balance control, and may even cause serious accidents such as fire and explosion due to the failure to take reasonable control. Therefore, a sampling component for the battery cell is disposed in the battery, allowing for appropriate control and handling to be implemented upon detecting any abnormalities.

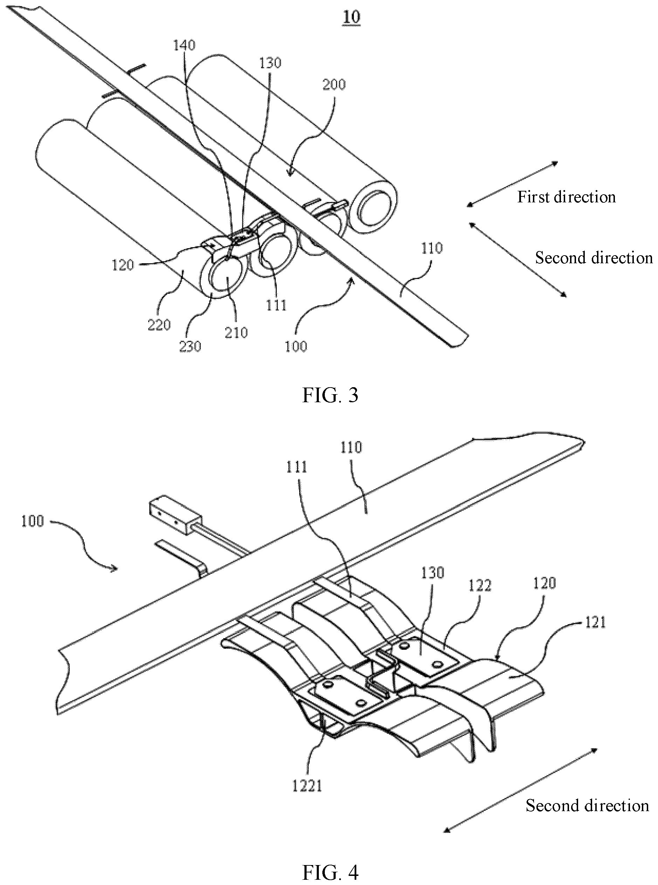

For non-square-shell shaped battery cells, such as cylindrical battery cells and prismatic battery cells, when multiple battery cells are arranged and/or stacked to form a battery, there is some unnecessary space between adjacent faces of the battery cells. In this application, the cylindrical battery is used as an example. Referring to FIG. 3, the cylindrical battery cells arranged along the first direction are adjacent by side face, and there is a large space between adjacent side faces. The inventors have found through research that the space can be utilized to arrange the sampling assembly of the battery in order to accommodate all parts of the sampling assembly in this space, thereby minimizing any protrusions from the battery cell and preventing an increase in the overall size of the battery.

Some existing sampling assemblies are electrically connected to the poles of the battery cells via components to collect signals related to some parameters of the battery cells. The collected signals are transmitted to the battery management system through a flexible flat cable (FFC) for parameter adjustment and control of each battery cell. To collect signals from protruding poles on end covers of cylindrical battery cells, a sampling ring structure is generally used to electrically connect to the poles so as to collect electrical signals. Since reliable electrical signal acquisition requires interference fit between the sampling ring and the pole, it is necessary to provide an additional pressing force to snap the sampling ring onto the pole. Performing such pressing assembly operation can be challenging, time-consuming, and not easily automated. Moreover, during assembly, the sampling ring is likely to deform and parts may be damaged, which affects the product yield. Failure to detect the poor assembly conditions in time may further affect sampling and battery management of the battery as a whole.

In order to solve the above problems and make the connection between the sampling ring and the pole more reliable and impedance more stable, welding is generally used to electrically connect the sampling ring to the pole. However, during welding, the heat is high and it is easy to burn the cladding of the sampling ring, and metal particles scattered during welding can affect the welding quality at the welding interface or lead to the problem of false welding. Moreover, during pole welding, if the welding location is not properly placed, it is highly likely to weld through the end cover or housing, which can result in leakage risks for the battery cell. On the other hand, the welding connection method involves assembling and welding the pole, sampling ring, and flexible flat cable in a specific sequence, which requires two welding processes. This complex and cumbersome operation affects the efficiency of mass production.

In light of the foregoing problems of the sampling assembly, the inventors have developed a new sampling assembly, that is, the sampling assembly of this application, where the pole and the sampling member (flexible flat cable) are directly welded using a lead and a bonding member to provide reliable sampling function. In addition, the space between the poles of the battery cell and between the battery cells is utilized, with no additional space in the battery being occupied, thus improving the energy density of the battery.

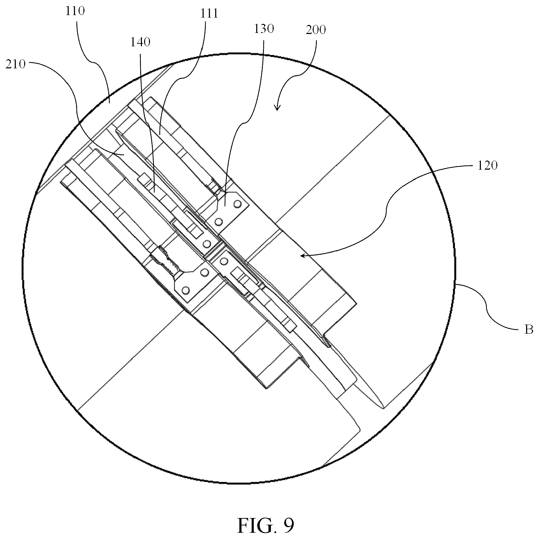

In view of this, embodiments of a first aspect of this disclosure provide a sampling assembly 100 as shown in FIGs. 3 to 5 and FIGs. 8 and 9. The sampling assembly 100 is for a battery 10, the battery 10 including at least two battery cells 200 arranged along a first direction. Specifically, the sampling assembly 100 includes a sampling member 110, a support base 120, a conductive connecting piece 130, and a bonding member 140. The sampling member 110 is configured to transmit sample signals, the sampling member 110 having a lead 111. The support base 120 is configured to provide support between two of the battery cells 200 adjacent along the first direction. The conductive connecting piece 130 is provided on the support base 120, and the lead 111 is connected to the conductive connecting piece 130. One end of the bonding member 140 is for connecting to the conductive connecting piece 130, and the other end of the bonding member 140 is for connecting the battery cell 200 to collect sample signals of the battery cell 200. The first direction is perpendicular to an arrangement direction in which the battery cells 200 are connected in series.

According to the sampling assembly 100 in the embodiments of this disclosure, the sampling member 110 of the sampling assembly 100 is connected to the conductive connecting piece 130 via the lead 111, and the conductive connecting piece 130 is connected to the battery cell 200 in the battery 10 via the bonding member 140, thereby achieving an electrical connection between the sampling member 110 and the battery cell 200, so that the operating parameters of the battery cell 200 are collected by the sampling member 110, and the sampling member 110 further transmits sample signals characterizing the operating parameters of the battery cell 200 to an external monitoring device. In addition, in the embodiments of this disclosure, the bonding member 140 is used to connect the conductive connecting piece 130 to the battery cell 200. As compared with a way of sleeving the battery cell with a sampling ring in the prior art, the sampling assembly 100 in the embodiments of this disclosure requires no downward pressure during assembly onto the battery 10, and only a laser welding device is used to connect the bonding member 140 to the conductive connecting piece 130 and to connect the bonding member 140 to the battery cell 200. As a result, the assembly is more efficient, and deformation or damage is avoided, resulting in a higher assembly yield. In summary, the sampling assembly 100 in the embodiments of this disclosure is conducive to improving the assembly efficiency as well as the yield of products.

The sampling member 110 is a component that can collect signals for the parameters of the battery cell 200. As shown in FIG. 3, the sampling member 110 can extend in the arrangement direction in which a plurality of battery cells 200 are connected in series, and a plurality of leads 111 are spaced apart in the extension direction of the sampling member 110, each lead 111 being connected to one respective conductive connecting piece 130. In other words, sample signals of the plurality of battery cells 200 connected in series can be collected by using one sampling member 110. The sample signal is a parameter that can characterize the operating state of the battery cell 200, such as voltage and internal resistance. The lead 111 is a cable of any type that can transmit electrical signals, and the lead 111 is not limited to a specific type in this application. The conductive connecting piece 130 is a sheet structure with conductive properties, such as a metal sheet. The bonding member 140 is a connection structure that can be electrically connected to the conductive connecting piece 130 and the battery cell 200 by laser welding, for example, a metal wire and a metal strip.

As shown in FIG. 3, the support base 120 has a shape adapted to the battery cell 200 so that it can provide stable support between two battery cells 200 adjacent along the first direction. In addition, there is some redundant space between two battery cells 200 adjacent along the first direction, and part of the structure of the support base 120 can be accommodated in the redundant space to minimize any protrusions from the battery cell 200 and prevent an increase in the overall size of the battery 10.

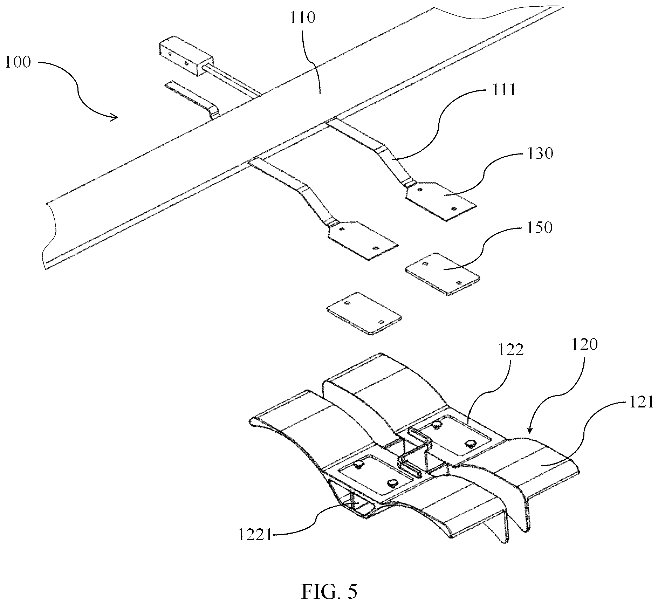

In some embodiments of this disclosure, as shown in FIGs. 4 and 5, the support base 120 includes a positioning portion 121 and a support portion 122. The positioning portion 121 is configured to fit the profile of the battery cell 200, that is, if the battery cell 200 is cylindrical, the positioning portion 121 is designed with a circular surface to fit the cylindrical battery cell 200; and if the battery cell 200 is prismatic, the positioning portion 121 is designed with a prismatic surface to fit the prismatic battery cell 200. The support portion 122 is located between two positioning portions 121 adjacent along the first direction, such that, with the two positioning portions 121 fitting closely to the corresponding battery cells 200, the support portion 122 is in the redundant space between the two battery cells 200. It can be understood that the positioning portion 121 is a structure on the support base 120 primarily for positioning the battery cell 200, and the support portion 122 is a structure on the support base 120 primarily for providing a mounting base for the conductive connecting piece 130. In this embodiment, the positioning portion 121 is used to fit the profile of the battery cell 200, and the positioning portion 121 of the support base 120 can fit well with the battery cell 200. The support portion 122 of the support base 120 is between the two positioning portions 121, thereby enabling the support base 120 to be positioned stably between two of the battery cells 200 adjacent along the first direction.

Further, as shown in FIG. 3, the profile of the battery cell 200 includes a side face 220 of the battery cell 200 and an end face 230 of the battery cell 200. For example, the battery cell 200 is a cylindrical battery. In this case, the side face 220 of the battery cell 200 is a cylindrical surface around a circumference of the battery cell 200, and the end face of the battery cell 200 is a circular surface located at an end of the battery cell 200. In this embodiment, a portion of the positioning portion 121 of the support base 120 fits the side face 220 of the battery cell 200 and another portion fits the end face 230 of the battery cell 200, thereby enabling the positioning portion 121 to be positioned at an end of the battery cell 200. Typically, a pole 210 of the battery cell 200 is located at an end of the battery cell 200, and the part of the battery cell 200 that is connected to the bonding member 140 may be the pole 210 of the battery cell 200. In the embodiments of this disclosure, the positioning portion 121 can be positioned at the end of the battery cell 200, thereby allowing the support base 120 to provide stable support between two of the battery cells 200 adjacent along the first direction and be at the end of the battery cell 200. This helps reduce the length of the bonding member and thus shorten the working stroke of the laser welding device during laser welding, thereby improving the efficiency of assembling the sampling assembly 100 to the battery 10.

In some embodiments of this disclosure, the bonding member 140 may be an aluminum wire. The material of the pole 210 of the battery cell 200 is typically aluminum. Therefore, using an aluminum wire as the bonding member 140 can ensure that the bonding member 140 and the pole 210 are made of the same material, so that the bonding after welding is stronger. In some other embodiments, the bonding member 140 may alternatively be a metal wire other than an aluminum wire.

In some embodiments of this disclosure, the conductive connecting piece 130 is a metal piece. In a preferred example, the conductive connecting piece 130 may be a nickel sheet, which is less susceptible to oxidation by oxygen in the air at room temperature and therefore has better corrosion resistance. Nickel and aluminum can be easily welded together. Therefore, if the bonding member 140 is an aluminum wire and the conductive connecting piece 130 is a nickel sheet, the resulting weld between the bonding member 140 and the conductive connecting piece 130 is stronger and false welding is less likely to occur.

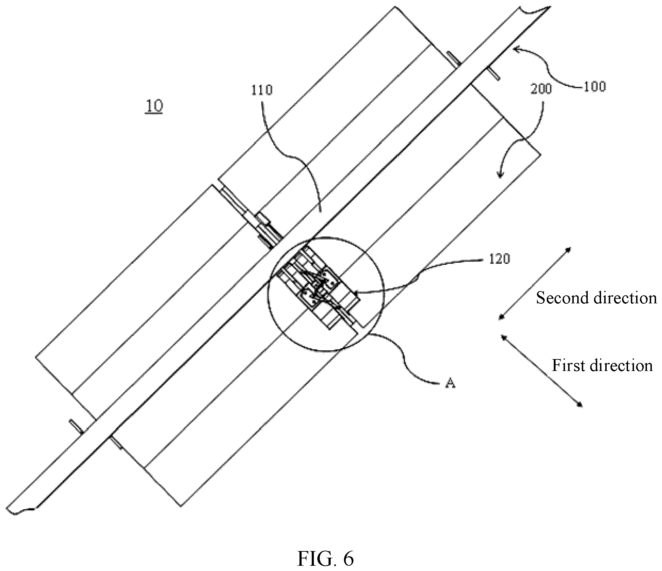

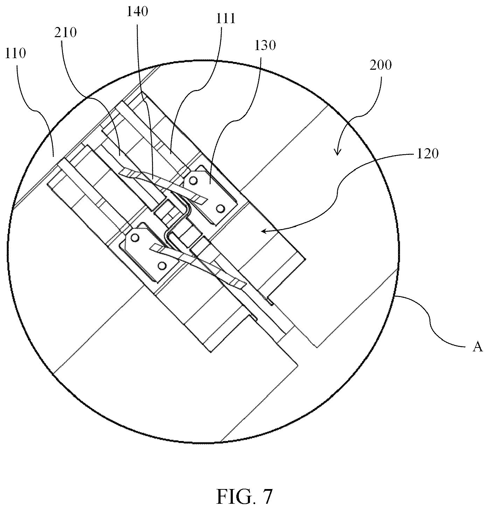

In some embodiments of this disclosure, as shown in FIGs. 5 to 7, the conductive connecting piece 130 is a sheet structure with all parts provided on the support portion 122. However, there is a positional difference between the pole 210 and the conductive connecting piece 130 in a direction (that is, a second direction) in which the batteries 10 are connected in series. In this case, the laser welding device can be programmed to weld the bonding member 140 to both the conductive connecting piece 130 and the pole 210 of the battery cell 200.

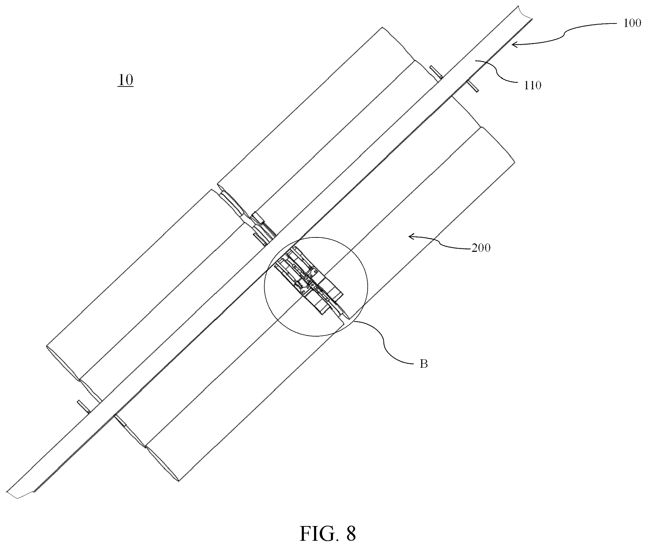

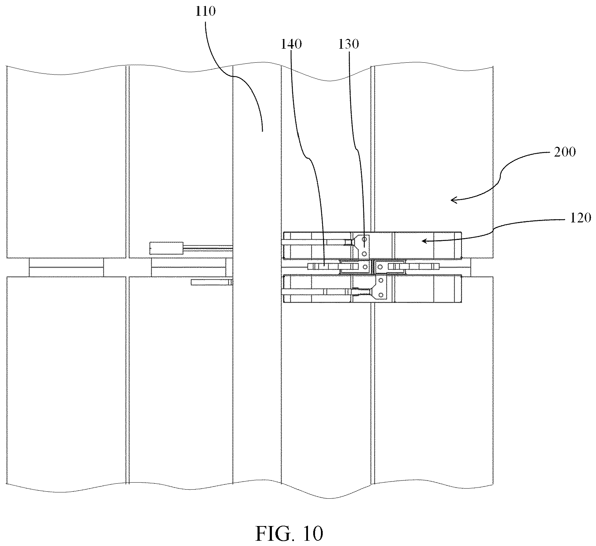

In some other embodiments of this disclosure, as shown in FIGs. 8 to 13, the conductive connecting piece 130 includes a first section 131, a second section 132, and a third section 133 connected in sequence. The first section 131 and the third section 133 are not coplanar so that the conductive connecting piece 130 forms a stepped structure. The lead 111 is connected to the first section 131, and one end of the bonding member 140 is connected to the third section 133. In this embodiment, the conductive connecting piece 130 forms a stepped structure. The first section 131 of the stepped structure is connected to the lead 111, the third section 133 is connected to the bonding member 140, and a connection to the second section 132 for transition enables the third section 133 to extend to be side-by-side with the pole 210 of the battery cell 200 (that is, the third section 133 and the pole 210 are adjacent in the first direction). In this way, the length of the bonding member 140 can be further reduced, whereby the working stroke of the laser welding device during laser welding can be further reduced, thereby further improving the efficiency of assembling the sampling assembly 100 to the battery 10. In addition, when a large number of battery cells 200 are arranged along the first direction, all bonding members 140 can be generally in a straight line. Thus, the laser welding device can continuously implement laser welding by performing only a relatively simple control program, so as to weld the bonding members 140 that are in the straight line one by one, that is, the welding process is easy to implement and control.

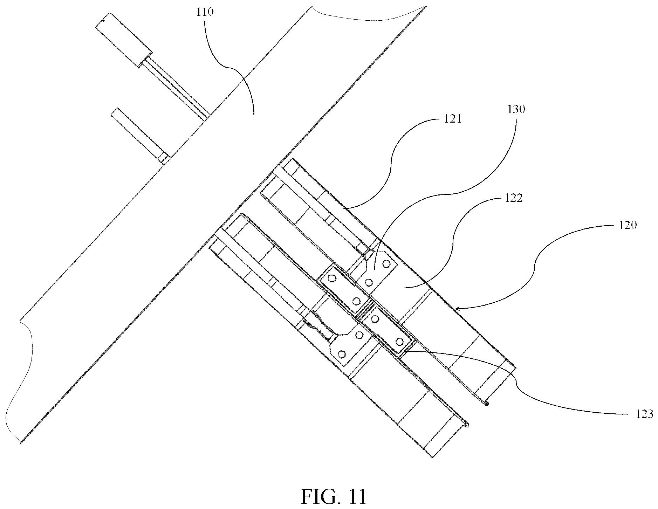

Further, as shown in FIG. 11, the support base 120 further includes a spacer 123, the spacer 123 being provided on a side of the support portion 122 back from the battery cell 200, and the spacer 123 being configured to space apart adjacent sampling assemblies 100 arranged along the second direction. The second direction is an arrangement direction in which the plurality of battery cells 200 are connected in series. In this embodiment, the support base 120 further includes the spacer 123 configured to space apart the adjacent sampling assemblies 100 arranged along the second direction. When the sampling assembly 100 is assembled on the battery 10, the spacer 123 can abut against a support base 120 of an adjacent sampling assembly 100, thereby enhancing the stability of the positioning of the support base 120 and preventing the support base 120 from tampering in the second direction. Specifically, the spacer 123 can be a rectangular block structure. This regular shape can make the sampling assembly 100 evenly stressed when the spacer 123 abuts against the support base 120 of the adjacent sampling assembly 100.

Further, in a case that the support base 120 further includes the spacer 123, the third section 133 can be further fixed to the spacer 123. As the spacer 123 is provided on a side of the support portion 122 back from the battery cell 200, the spacer 123 is in a position roughly side-by-side with the pole 210 of the battery cell 200. The third section 133 of the conductive connecting piece 130 is fixed to the spacer 123, meeting the position setting requirements of the third section 133 (to enable the third section 133 and the pole 210 to be adjacent along the first direction) and also helping improve the structural strength and structural rigidity of the conductive connecting piece 130, thus preventing the conductive connecting piece 130 from deforming when subjected to external forces.

Further, the battery cell 200 is provided with a pole 210 protruding from the end face 230 of the battery cell 200. In a case that the support base 120 provides support between the two battery cells 200 adjacent along the first direction, the bonding member 140 has substantially same heights at two ends. In this embodiment, the bonding member 140 has substantially same heights at the two ends, that is, an end of the bonding member 140 connected to the third section 133 is at substantially the same height as the end of the bonding member 140 connected to the pole 210. In this way, the laser welding device can sequentially perform the operations of welding the bonding member 140 to the third section 133 and welding the bonding member 140 to the pole 210 without adjusting the downward pressure to further improve the assembly efficiency.

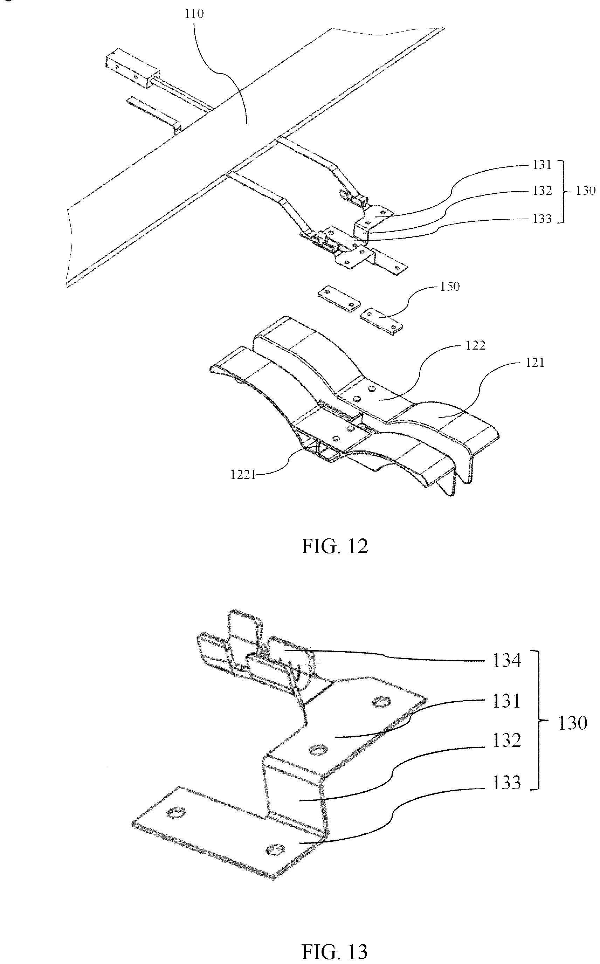

In some embodiments of this disclosure, as shown in FIG. 13, the conductive connecting piece 130 is provided with a wrapping portion 134 for wrapping at least part of the lead 111. As a result, the lead 111 and the conductive connecting piece 130 are connected more firmly, thereby avoiding accidental separation between the two. Specifically, the wrapping portion 134 may be a semi-circular arc-shaped structure or a U-shaped structure, so that a groove that can accommodate the lead 111 is formed in the wrapping portion 134, and when the lead 111 is placed in the groove during assembly, the semi-circular arc-shaped structure or the U-shaped structure can be deformed by an external force to cause the groove to shrink and thereby clamp the lead 111.

In some embodiments of this disclosure, as shown in FIGs. 5 and 12, the sampling assembly 100 further includes a metal gasket 150, the metal gasket 150 being provided between the conductive connecting piece 130 and the support base 120. Since the conductive connecting piece 130 is usually thin (for example, when the conductive connecting piece 130 is a nickel piece, its thickness is around 3 mm), it is likely to weld through the conductive connecting piece 130 during laser welding, which can lead to the problem of poor welding. In this embodiment, the metal gasket 150 is provided between the conductive connecting piece 130 and the support base 120, so that even if the conductive connecting piece 130 is welded through, the bonding member 140 can still achieve an electrical connection to the conductive connecting piece 130 through the metal gasket 150, thereby avoiding the problem of poor welding.

In some embodiments of this disclosure, the support base 120 is made of an insulating material. As a result, the support base 120 can separate the bonding member 140, the conductive connecting piece 130, and the battery cell 200 to ensure insulation performance.

In some embodiments of this disclosure, the support portion 122 is an internally hollow trapezoidal block, stiffeners 1221 being provided in a cavity of the trapezoidal block. In this embodiment, the support portion 122 of the support base 120 is an internally hollow trapezoidal block, and the top face of the trapezoidal block is a flat plane, which can withstand the welding pressure during laser welding. In addition, the support base 120 is hollow inside, so that the support base 120 as a whole is an equal wall thickness structure, thus facilitating the implementation of the injection molding process. Further, the support portion 122 is trapezoidal in shape, facilitating utilizing the gap between two adjacent battery cells 200 in the first direction to position the support portion 122. In addition, the provision of stiffeners 1221 in the cavity of the trapezoidal block can improve the structural strength and structural stiffness of the support portion 122.

As shown in FIGs. 3 and 8, embodiments of the second aspect of this disclosure provide a battery 10, the battery 10 including the sampling assembly 100 in the embodiments of the first aspect. Further, the battery 10 further includes at least two battery cells 200 arranged along the first direction, a support base 120 provides support between two of the battery cells 200 adjacent along the first direction, and the other end of the bonding member 140 is for connecting to the battery cell 200.

According to the battery 10 in the embodiments of this disclosure, the sampling assembly 100 of the battery 10 is connected to the conductive connecting piece 130 via the lead 111, and the conductive connecting piece 130 is connected to the battery cell 200 in the battery 10 via the bonding member 140, thereby achieving an electrical connection between the sampling member 110 and the battery cell 200, so that the operating parameters of the battery cell 200 are collected by the sampling member 110, and the sampling member 110 further transmits sample signals characterizing the operating parameters of the battery cell 200 to an external monitoring device. In addition, in the embodiments of this disclosure, the bonding member 140 is used to connect the conductive connecting piece 130 to the battery cell 200. As compared with a way of sleeving the battery cell 200 with a sampling ring in the related art, the sampling assembly 100 in the embodiments of this disclosure requires no downward pressure during assembly onto the battery 10, and only a laser welding device is used to connect the bonding member 140 to the conductive connecting piece 130 and to connect the bonding member 140 to the battery cell 200. As a result, the assembly is more efficient, and deformation or damage is avoided, resulting in a higher assembly yield.

Embodiments of a third aspect of this disclosure provide an electric device, the electric device including the battery 10 in the embodiments of the second aspect.

The electric device according to the embodiments of this disclosure is based on the same inventive concept as the battery 10 in the embodiments of the second aspect. Therefore, the electric device in the embodiments of this disclosure is capable of obtaining all the beneficial effects of the battery 10 in the embodiments of the second aspect.

Embodiments of a fourth aspect of this disclosure provide a sampling assembly 100 manufacturing method, the battery 10 including at least two battery cells 200 arranged along a first direction. The method is characterized by including:
providing a sampling member 110 configured to transmit sample signals, the sampling member 110 having a lead;
providing a support base 120 configured to provide support between two of the battery cells 200 adjacent along the first direction;
providing a conductive connecting piece 130, the conductive connecting piece 130 being provided on the support base 120, and the lead being connected to the conductive connecting piece 130; and
providing a bonding member 140, one end of the bonding member 140 being for connecting to the conductive connecting piece 130, and the other end of the bonding member 140 being for connecting to the battery cell 200 to collect sample signals of the battery cell 200.

According to the sampling assembly manufacturing method in the embodiments of this disclosure, the sampling member 110 of the sampling assembly 100 manufactured by using this method is connected to the conductive connecting piece 130 via the lead, and the conductive connecting piece 130 is connected to the battery cell 200 in the battery 10 via the bonding member 140, thereby achieving an electrical connection between the sampling member 110 and the battery cell 200, so that the operating parameters of the battery cell 200 are collected by the sampling member 110, and the sampling member 110 further transmits the sample signals characterizing operating parameters of the battery cell 200 to an external monitoring device. In addition, in the embodiments of this disclosure, the bonding member 140 is used to connect the conductive connecting piece 130 to the battery cell 200. As compared with a way of sleeving the battery cell 200 with a sampling ring in the related art, the sampling assembly 100 in the embodiments of this disclosure requires no downward pressure during assembly onto the battery 10, and only a laser welding device is used to connect the bonding member 140 to the conductive connecting piece 130 and to connect the bonding member 140 to the battery cell 200. As a result, the assembly is more efficient, and deformation or damage is avoided, resulting in a higher assembly yield. In summary, the sampling assembly 100 in the embodiments of this disclosure is conducive to improving the assembly efficiency as well as the yield of products.

According to the embodiments of this application, the conductive connecting piece 130 of a stepped structure is used so that the top face of part of the structure (specifically, the third section 133) of the conductive connecting piece 130 is kept at the same level as the top arc face of the pole 210 of the battery cell 200, thereby keeping the two ends of the bonding member 140 on the same horizontal plane. This facilitates a reduction in the length of the bonding member 140, whereby the working stroke of the laser welding device during laser welding can be further reduced, thereby further improving the efficiency of assembling the sampling assembly 100 to the battery 10. In the process, when a large number of battery cells 200 are arranged along the first direction, all bonding members 140 can be generally in a straight line. Thus, the laser welding device can continuously implement laser welding by performing only a relatively simple control program, so as to weld the bonding members 140 that are in the straight line one by one, that is, the welding process is easy to implement and control, better facilitating manufacturing efficiency.

According to another embodiment of this application, an ordinary conductive connecting piece 130 is used and no bending is required, and therefore bending mold making is not required, but the top face of the conductive connecting piece 130 and the arc top face of the pole 210 of the battery cell 200 are not kept at the same level, that is, the ends of the bonding members 140 are not on the same plane. For the parts, the conductive connecting piece 130 does not require bending mold making, and therefore the processing molding accuracy requirements are lower. In addition, when the conductive connecting piece 130 is assembled to the support base 120, there is no need to consider too much the relative position relationship, making the assembly easier.

The foregoing descriptions are merely preferred specific embodiments of this disclosure, but are not intended to limit the protection scope of this disclosure. Any variation or replacement readily figured out by persons skilled in the art within the technical scope disclosed in this disclosure shall fall within the protection scope of this disclosure. Therefore, the protection scope of this disclosure shall be subject to the protection scope of the claims.

## Claims

1. A sampling assembly for a battery, the battery comprising at least two battery cells arranged along a first direction, **characterized in that** the sampling assembly comprises:
a sampling member configured to transmit sample signals, the sampling member having a lead;
a support base configured to provide support between two of the battery cells adjacent along the first direction;
a conductive connecting piece, the conductive connecting piece being provided on the support base, and the lead being connected to the conductive connecting piece; and
a bonding member, one end of the bonding member being for connecting to the conductive connecting piece, and the other end of the bonding member being for connecting to the battery cell to collect sample signals of the battery cell.

2. The sampling assembly according to claim 1, **characterized in that** the support base comprises a positioning portion and a support portion, the positioning portion being configured to fit a profile of the battery cell, and the support portion being located between two positioning portions adjacent along the first direction.

3. The sampling assembly according to claim 2, **characterized in that** the profile of the battery cell comprises a side face of the battery cell and an end face of the battery cell.

4. The sampling assembly according to claim 2 or 3, **characterized in that** the conductive connecting piece is a sheet structure with all parts provided on the support portion.

5. The sampling assembly according to claim 2 or 3, **characterized in that** the conductive connecting piece comprises a first section, a second section, and a third section connected in sequence, the first section and the third section not being coplanar so that the conductive connecting piece forms a stepped structure, the lead being connected to the first section, and one end of the bonding member being connected to the third section.

6. The sampling assembly according to claim 5, **characterized in that** the support base further comprises a spacer, the spacer being provided on a side of the support portion back from the battery cell, and the spacer being configured to space apart adjacent sampling assemblies arranged along a second direction.

7. The sampling assembly according to claim 6, **characterized in that** the third section is fixed to the spacer.

8. The sampling assembly according to claim 5, **characterized in that** the battery cell is provided with a pole protruding from the end face of the battery cell; and
in a case that the support base provides support between the two battery cells adjacent along the first direction, the bonding member has substantially same heights at two ends.

9. The sampling assembly according to any one of claims 1 to 7, **characterized in that** the conductive connecting piece is provided with a wrapping portion for wrapping at least part of the lead.

10. The sampling assembly according to any one of claims 1 to 7, **characterized in that** the sampling assembly further comprises a metal gasket, the metal gasket being provided between the conductive connecting piece and the support base.

11. The sampling assembly according to any one of claims 1 to 7, **characterized in that** the support base is made of an insulating material.

12. The sampling assembly according to any one of claims 2 to 7, **characterized in that** the support portion is an internally hollow trapezoidal block, stiffeners being provided in a cavity of the trapezoidal block.

13. A battery, **characterized by** comprising the sampling assembly according to any one of claims 1 to 12, wherein the battery further comprises at least two battery cells arranged along a first direction, the support base provides support between two of the battery cells adjacent along the first direction, and the other end of the bonding member is for connecting to the battery cell.

14. An electric device, **characterized by** comprising the battery according to claim 13.

15. A sampling assembly manufacturing method, a battery comprising at least two battery cells arranged along a first direction, **characterized by** comprising:
providing a sampling member configured to transmit sample signals, the sampling member having a lead;
providing a support base configured to provide support between two of the battery cells adjacent along the first direction;
providing a conductive connecting piece, the conductive connecting piece being provided on the support base, and the lead being connected to the conductive connecting piece; and
providing a bonding member, one end of the bonding member being for connecting to the conductive connecting piece, and the other end of the bonding member being for connecting to the battery cell to collect sample signals of the battery cell.
